# EUROPEAN PATENT SPECIFICATION

(11) **EP 3 734 214 B1**
(45) Date of publication and mention of the grant of the patent: **06.09.2023**
(21) Application number: 18896705.3
(22) Date of filing: 27.12.2018
(51) Int. Cl.: B21D 39/06, B21D 53/08, F28D 15/02, H01L 21/48, H01L 23/427, H05K 7/20, B23P 15/26, F28F 1/32

(54) **COOLING DEVICE**
KÜHLVORRICHTUNG
DISPOSITIF DE REFROIDISSEMENT

(30) Priority: 28.12.2017 JP 2017253884
(43) Date of publication of application: 04.11.2020
(73) Proprietor: FURUKAWA ELECTRIC CO., LTD., Chiyoda-ku Tokyo 100-8322 (JP)
(72) Inventor: SASAKI Chiyoshi, Tokyo 100-8322 (JP); ISEMURA Masakazu, Tokyo 100-8322 (JP); KATAYAMA Takahiro, Tokyo 100-8322 (JP)
(74) Representative: Gunzelmann, Rainer
(86) International application number: PCT/JP2018/048047
(87) International publication number: WO 2019/131834

(56) References cited:
- WO-A1-99/39145
- WO-A1-2016/104728
- WO-A1-2017/077619
- CN-U- 207 976 030
- CN-Y- 2 560 098
- CN-Y- 2 736 931
- JP-A- H11 351 769
- JP-A- 2004 125 381
- JP-A- 2007 218 439
- JP-U- S6 083 255
- US-A- 5 826 645
- US-A1- 2003 005 584
- US-A1- 2007 029 072
- US-A1- 2008 121 378
- US-A1- 2009 038 782
- US-A1- 2011 162 206
- US-B1- 9 429 370

## Description

### Technical Field

The present invention relates to a cooling device that cools electrical and electronic components and other components, and particularly relates to a cooling device that cools electrical and electronic components installed in a mobile unit such as a railway vehicle.

### Background Art

A cooling device, which is used to cool a control device or other devices using a semiconductor element, has been conventionally known as cooling a heating element by using latent heat generated when refrigerant boils.

As an example of the cooling device described above, a cooler has been proposed in which a plurality of tanks with a circular tubular shape are embedded in a base block that receives heat of a heating element such as a semiconductor element. A plurality of thin pipes are provided in a standing manner from the side of the exposed portion of the tank, and a plurality of fins are attached to the pipes, so that the cooler is capable of cooling heat of the heating element by using outside air (Patent Literature 1).

However, the cooler with the pipes installed perpendicularly to the side of the base block is mounted on a vehicle, and when the vehicle runs on an incline, this may lead to a state where the space in the tank is partially filled with refrigerant in liquid form in the axial direction of the circular tube of the tank and then the liquid refrigerant may reach the pipes, or there is no refrigerant in liquid form at the bottom of the tank.

Thus, to aim at improving the cooling performance, a cooler has been proposed. The cooler includes a pipe formed of a base end portion having a connection end connected to a tank embedded on one side of a base block, and a heat radiating portion bent from the base end portion and having a closed end on the tip end side. The base end portion is inclined upward from the connection end at a predetermined first inclination angle relative to the horizontal direction. The heat radiating portion is provided at a second inclination angle equal to or greater than zero degrees and smaller than the first inclination angle of the base end portion relative to the horizontal direction. In the tank, the liquid level of refrigerant is set at a position lower than the heat radiating portion (Patent Literature 2).

However, in the cooler described above, the base block and each tank are joined integrally by soldering. Since lead solder is used in the joined portion between the base block and multiple tanks, this increases the environmental impacts.

In view of the environmental impacts, a method using lead-free solder instead of the lead solder is considered. However, the lead-free solder has lower wettability compared to the lead solder and thus the joining force can become unstable. For this reason, there are concerns about the contact thermal conductance in a joined portion between the base block and a heat pipe, and about the resistance to vibration in the joined portion when the cooler is used in a mobile unit such as a vehicle.

Meanwhile, a crimping method has been proposed, which does not use joining materials such as solder. In this crimping method, a base block made of metal is provided with grooves or holes in which a plurality of heat pipes are held, and is also provided with protruding portions intended for crimping. With the heat pipes accommodated in the grooves or holes, the protruding portions are crimped to fix the heat pipes to the base block (Patent Literature 3).

WO 2016/104728 A1 discloses a heat pipe fixed to a base block by a screw bracket.

JP S60 83255 U discloses a heat receiving plate including a recess for accommodating heat pipes. The recess includes retaining parts protruding in the thickness direction of the heat receiving plate.

US 2009/038782 A1 discloses a base having a long wall part and a short wall part at opposite sides of a recess. The wall parts both extend along the thickness direction of the base.

US 9 429 370 B1 discloses a heat pipe clamped between a top clamp 113 and a bottom camp.

US 2003/005584 A1 discloses a heat pipe accommodated in a recess between two tabs protruding in the thickness direction of the main body.

US 2011/162206 A1 a heat pipe received in a slot of a fin.

US 5 826 645 A discloses a heat pipe accommodated in a groove of a heat sink. The sidewall of the groove protrudes in the thickness direction of the heat sink and the heat pipe is inclined relative to the thickness direction of the heat sink.

JP 2004 125381 A discloses a heat pipe unit fixed by crew brackets to a base block.

WO 99/39145 A1 discloses a cooling plate including a groove for accommodating a heat pipe. The walls of the groove protrude along the thickness direction of the cooling plate. The heat pipe has a heat dissipation portion inclined with respect to the thickness direction of the cooling plate.

JP 2007 218439 A discloses a heat receiving member including a groove for accommodating a heat pipe. The groove has rising walls protruding along the thickness direction of the heat receiving member.

WO 2017/077619 A1 discloses a heat pipe accommodated in a recess of a heat receiving block. The recess 11 protrusions protruding in the thickness direction of the heat receiving block.

JP H11 351769 A discloses a U-shape heat pipe joined with a base plate.

CN 2 560 098 Y discloses a method of joining the heat pipe with a base through an additional pressing strip and a screw.

### Document List

### Patent Literatures

Patent Literature 1: Japanese Patent Application Publication No. 2004-125381
Patent Literature 2: International Publication No. WO 2016104729
Patent Literature 3: International Publication No. WO 2017077619

### Summary of Invention

### Technical Problem

However, in a heat sink including a heat pipe, a fin is attached to a heat radiating portion of the heat pipe. Thus, the center-of-gravity position of the heat sink is offset toward the heat radiating portion. Thus, in the crimping method as described above, in a case where vibration or shock is applied to the heat sink, a moment of force is generated in a fixed portion of the heat pipe to the base block around the axis of the center-of-gravity position. When this moment of force is repeatedly generated, the fixed portion may become loosened and this may degrade the contact thermal conductance. Therefore, in both the method using the lead-free solder and the crimping method, there are concerns about the contact thermal conductance and the resistance to vibration.

It is an object of the present invention to provide a cooling device that can improve the reliability of joining between a base block and a heat pipe, while reducing the environmental impacts, and can also achieve both high contact thermal conductance and high resistance to vibration, and to provide a manufacturing method of the cooling device.

### Solution to Problem

To achieve the above object, a cooling device of the present invention is set out in claim 1.

It is preferable that the pair of wall parts is a pair of elongated protruding portions protruding along an outer peripheral surface of the first tubular portion, and extending along a longitudinal direction of the first tubular portion, and each of the pair of elongated protruding portions includes a press-contact surface that press-contacts an outer peripheral surface of the first tubular portion.

It is more preferable that a gap portion with a groove-like shape is formed between tip end portions of the pair of wall parts.

The cooling device may further include a fin member located between the base block and the fin group, wherein the fin member may include a plate-like base portion crimped and fixed between the first tubular portion and the pair of wall parts, and a fin portion connected to the plate-like base portion and provided in a standing manner through the gap portion formed between the tip end portions of the pair of wall parts.

The base block may be located along a vertical direction. The first tubular portion of the heat pipe may be provided along a horizontal direction.

The pair of wall parts protrude at an angle equal to, or nearly equal to, a standing angle of the second tubular portion relative to the base block.

To achieve the above object, a manufacturing method of a cooling device of the present invention is set out in claim 5.

The pair of wall parts having an equal or nearly equal length in an extending direction is formed, and in the crimping step, the pair of wall parts is pressed by a pressing force in a vertical direction in a state where the base block is inclined such that a pair of tip end portions of the pair of wall parts is maintained at a same height.

In the crimping step, in a state where the pair of wall parts protrudes in a vertical direction, a pressing force in the vertical direction may be applied to the pair of wall parts.

In the crimping step, a jig including a groove portion with an inverted U-shape may be used to press the groove portion against the pair of wall parts to press the pair of wall parts together.

### Effects of Invention

According to a cooling device of the present invention, the reliability of joining between the base block and the heat pipe can be improved, while the environmental impacts are reduced, and high contact thermal conductance and high resistance to vibration can both be achieved.

### Brief Description of Drawings

[FIG. 1] A schematic cross-sectional view showing the configuration of a cooling device according to an embodiment of the present invention.
[FIG. 2] A partial cross-sectional view showing the detailed configuration of the cooling device in FIG. 1.
[FIG. 3A] A cross-sectional view showing the detailed configuration of a base block after a heat pipe group has been fixed to the base block.
[FIG. 3B] A partially enlarged perspective view of the fixed portion in FIG. 3A.
[FIG. 3C] A cross-sectional view showing the detailed configuration of the base block before the heat pipe group is fixed to the base block.
[FIGs. 4A to 4D] Explanatory views for describing an example of a manufacturing method of the cooling device in FIG. 1.
[FIG. 5] A partial cross-sectional view showing a modification of the fixed portion of the heat pipe group to the base block in the cooling device in FIG. 1.
[FIG. 6A] A partially exploded perspective view of the fixed portion in FIG. 5.
[FIG. 6B] A partially enlarged cross-sectional view of the fixed portion in FIG. 6A.

### Description of Embodiment

Hereinafter, an embodiment of the present invention is described in detail with reference to the drawings.

### [Configuration of cooling device]

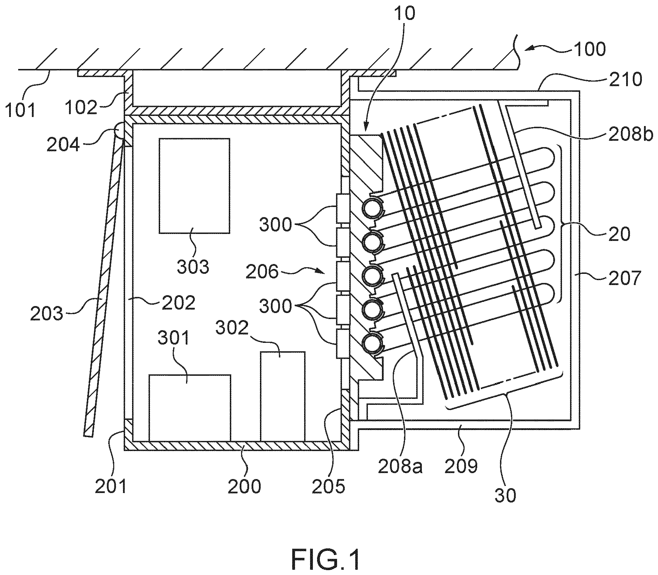

FIG. 1 is a schematic cross-sectional view showing the configuration of a cooling device according to an embodiment of the present invention. In the present embodiment, a railway vehicle is described as an example of a mobile unit having the cooling device installed therein. Note that the configuration of the cooling device and the installation position of the cooling device shown in FIG. 1 are merely an example. The cooling device of the present invention and the installation position of this cooling device are not limited to those shown in FIG. 1.

As shown in FIG. 1, a casing 200 in a sealed state is attached to an underfloor surface 101 of a vehicle 100 through an attachment 102. One side wall 201 of the casing 200 is formed with an opening 202. An opening-closing cover 203 that opens or closes the opening 202 is attached to the side wall 201 through a hinge 204 at the upper portion of the side wall 201. The opening-closing cover 203 is configured to be locked by a locking means (not shown) when the opening-closing cover 203 closes the opening 202.

Another side wall 205 of the casing 200 is formed with a window hole 206. The window hole 206 is closed by a base block 10 attached to the side wall 205 on the outside of the side wall 205. The casing 200 is thereby held in a sealed state. A plurality of electrical components 300, such as a heating element that is, for example, a semiconductor module, are attached to a part of the base block 10, which faces the interior of the casing 200. Inside the casing 200, other components 301, 302, and 303 that are respectively, for example, a snubber resistor, a snubber capacitor, and a gate amplifier are installed as other heating elements.

On the side wall 205 of the casing 200, a tubular cover 207 is attached such that the cover 207 extends along the airflow generated by running of the vehicle 100. Inside the cover 207, a cooling device 1 is accommodated. Support plates 208a and 208b that support and strengthen a heat pipe group 20 are also attached to the inside of the cover 207. The support plate 208a supports the heat pipe group 20 from below. For example, one end portion of the support plate 208a is fixed to a bottom wall 209 of the cover 207, while the other end portion of the support plate 208a is fixed to a part of the heat pipe group 20. The support plate 208b supports the heat pipe group 20 from above. For example, one end portion of the support plate 208b is fixed to a top wall 210 of the cover 207, while the other end portion of the support plate 208b is fixed to a part of the heat pipe group 20. The support plates 208a and 208b are thermally connected to the heat pipe group 20, and also serve as a heat radiating plate.

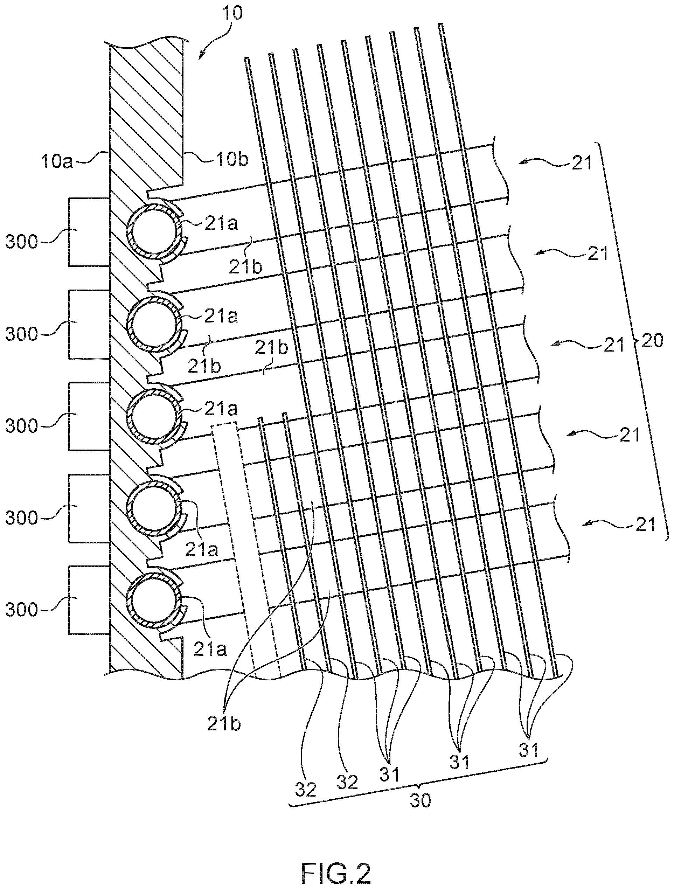

FIG. 2 is a partial cross-sectional view showing the detailed configuration of the cooling device 1 in FIG. 1. As shown in FIG. 2, the cooling device 1 includes the base block 10 including a back-side portion 10a thermally connected to the electrical components 300 that are heating elements, the heat pipe group 20 formed of a plurality of heat pipes 21, each of which includes a first tubular portion 21a and a second tubular portion 21b, the first tubular portion 21a being fixed to a front-side portion 10b of the base block 10 and being disposed along the planar direction of the base block 10, the second tubular portion 21b being connected to the first tubular portion 21a and being provided in a standing manner from the base block 10, and a fin group 30 formed of a plurality of fins 31, 31, ... fixed to the heat pipe group 20, the fins 31, 31, ... being parallel to each other in the standing direction of the heat pipe group 20.

The base block 10 is attached to the casing 200 along the side wall 205 in such a manner that the back-side portion 10a faces toward the casing 200, while the front-side portion 10b faces toward the cover 207 (FIG. 1). For example, the base block 10 is located along the vertical direction. The base block 10 is made of metal material such as aluminum or aluminum alloy, or copper or copper alloy.

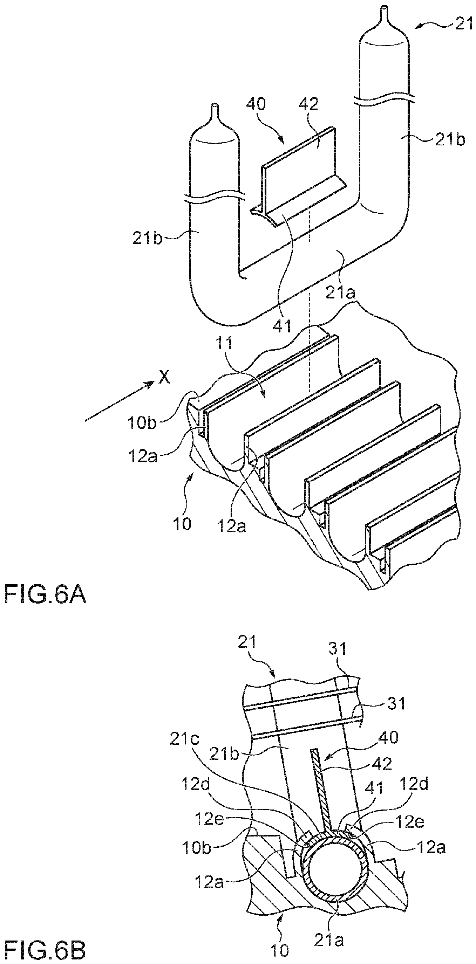

A plurality of heat pipes 21, 21, ... forming the heat pipe group 20 are provided next to and spaced apart from each other in an up-down direction, for example, in the vertical direction. Each of the heat pipes 21 is formed of a tubular member having, for example, a U-shape (see FIG. 6).

The first tubular portion 21a has, for example, a circular tubular shape, and is filled with an amount of operating fluid equivalent to between 30% and 40% of the overall volume. The second tubular portion 21b has, for example, a circular tubular shape that is the same as the shape of the first tubular portion 21a. The first tubular portion 21a and the second tubular portion 21b may have a circular shape, an oval shape, or other shape in cross-section in the width direction.

The first tubular portion 21a has a function of a heated portion to be heated by heat from the base block 10. The second tubular portion 21b has a function of a heat radiating portion that radiates heat from the first tubular portion 21a. As long as the first tubular portion 21a and the second tubular portion 21b are configured to implement their respective functions described above, the shape of the heat pipe 21 is not limited, but may be an L-shape or a looped shape, for example. The first tubular portion 21a and the second tubular portion 21b may be formed in one piece by bending a long pipe or other methods, or may be connected together by joining such as welding.

The fins 31, 31, ... forming the fin group 30 are provided next to and spaced apart from each other in the standing direction of the second tubular portion 21b such that, for example, the main surfaces of the fins 31, 31, ... are parallel to each other. The fin 31 includes one or a plurality of holes corresponding to the positions of the heat pipes 21. The fin 31 is fixed to the heat pipes 21 by, for example, press fitting.

The fin 31 has a function of the heat radiating portion that radiates heat from the second tubular portion 21b. That is, the fin 31 constitutes the heat radiating portion in cooperation with the second tubular portion 21b. As long as the fin 31 is configured to implement the function described above, the shape of the fin 31 is not limited.

It is preferable that the fin 31 is connected with all the heat pipes 21, 21, ... in the direction of the heat pipe group 20 in which the heat pipes 21, 21, ... are provided next to each other. However, a fin 32 may also be provided, which is connected with some of the heat pipes 21, 21, ... in the direction of the heat pipe group 20 in which the heat pipes 21, 21, ... are provided next to each other.

In the present embodiment, a plurality of first tubular portions 21a, 21a, ... are fixed to one another through the base block 10, while a plurality of second tubular portions 21b, 21b, ... are fixed to one another through the fin group 30. That is, the fin group 30, formed of the fins 31, 31, ... connected with the heat pipes 21, 21, ..., is regarded as a rigid body with a thickness whose value is obtained by multiplying the fin thickness by the number of fins. Therefore, even when vibration is applied to a heat sink formed of the heat pipe group 20 and the fin group 30, the respective distances between the heat pipes 21, 21, ... are still maintained by the fin group 30. This results in a structure in which a moment of force is minimally generated in each fixed portion between the base block 10 and each of the heat pipes 21 provided in a standing manner from the base block 10.

It is preferable to install the cooling device 1 below the underfloor surface 101 of the vehicle 100. In this case, for example, the base block 10 is located along the vertical direction, the first tubular portion 21a of the heat pipe 21 is provided along the horizontal direction, and the second tubular portion 21b of the heat pipe 21 is inclined upward toward the tip end of the second tubular portion 21b relative to the thickness direction of the base block 10 (FIG. 1). It is also preferable to provide the first tubular portion 21a with the longitudinal direction (axial direction) of the first tubular portion 21a extending along the traveling direction of the vehicle 100. It is further preferable to provide the fin 31 along the traveling direction of the vehicle 100. This can improve the cooling efficiency.

In the cooling device 1, heat from the electrical components 300 and heat in the casing 200 generated from the other components 301, 302, and 303 and the like are transmitted through the base block 10 to the first tubular portion 21a of the heat pipe 21, then transferred to the second tubular portion 21b by a change in phase of the operating fluid in the interior of the first tubular portion 21a, and radiated to the exterior of the second tubular portion 21b through the fin 31.

Next, the detailed configuration of the fixed portion of the heat pipe 21 to the base block 10 is described.

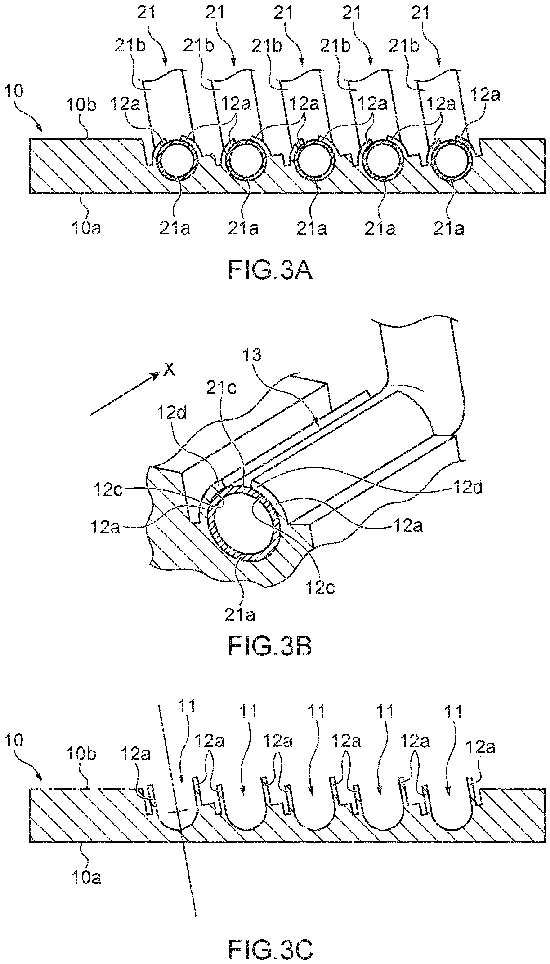

FIG. 3A is a cross-sectional view showing the detailed configuration of the base block 10 after the heat pipe group 20 has been fixed to the base block 10. FIG. 3B is a partially enlarged perspective view of the fixed portion in FIG. 3A. FIG. 3C is a cross-sectional view showing the configuration of the base block 10 before the heat pipe group 20 is fixed to the base block 10.

As shown in FIGs. 3A to 3C, the base block 10 includes a recessed part 11 extending in the longitudinal direction and the width direction and having the first tubular portion 21a accommodated therein, and a pair of wall parts 12a and 12a protruding from the opposite sides of the recessed part 11 in the width direction along the outer peripheral surface of the first tubular portion 21a. The heat pipe 21 is crimped and fixed to the recessed part 11 and the pair of wall parts 12a and 12a.

The recessed part 11 is provided along the planar direction of the base block 10 such that, for example, the longitudinal direction of the recessed part 11 extends horizontally, while the width direction of the recessed part 11 extends vertically. It is preferable to provide the recessed part 11 with the longitudinal direction of the recessed part 11 extending along the traveling direction of the vehicle 100 (see FIG. 1).

The pair of wall parts 12a and 12a is also provided along the planar direction of the base block 10 in the same manner as the recessed part 11. It is preferable that the wall part 12a extends along, for example, the extending direction of the recessed part 11, and extends parallel to the extending direction of the recessed part 11. The pair of wall parts 12a and 12a protrudes upward relative to the recessed part 11 in cross-section in the width direction, and is bent toward the center of the recessed part 11 in the width direction such that the wall parts 12a and 12a are brought closer to each other. Further, the pair of wall parts 12a and 12a, particularly, each base portion of the pair of wall parts 12a and 12a are formed at an angle equal to, or nearly equal to, the standing angle of the second tubular portion 21b relative to the base block 10. Particularly, the second tubular portion 21b of the heat pipe 21 is inclined upward toward the tip end of the second tubular portion 21b relative to the thickness direction of the base block 10, the pair of wall parts 12a and 12a are formed at an inclination angle equal to, or nearly equal to, the inclination angle of the second tubular portion 21b inclined upward toward the tip end.

It is preferable that the pair of wall parts 12a and 12a is a pair of elongated protruding portions protruding along an outer peripheral surface 21c of the first tubular portion 21a, and extending along the longitudinal direction (the X-direction in the drawing) of the first tubular portion 21a (FIG. 3B). In this case, each of the pair of elongated protruding portions includes a press-contact surface 12c that press-contacts the outer peripheral surface 21c of the first tubular portion 21a. The pair of elongated protruding portions includes a pair of press-contact surfaces 12c and 12c, so that the contact area between the first tubular portion 21a and the pair of elongated protruding portions is increased and accordingly a friction force is increased.

The pair of wall parts 12a and 12a has an equal or nearly equal length in the protruding direction. Because the pair of wall parts 12a and 12a has an equal or nearly equal length in the protruding direction, an equal or nearly equal pressing force can be simultaneously applied to both of the pair of wall parts 12a and 12a in a crimping step to be described later. A gap portion 13 with a groove-like shape may be formed between a pair of tip end portions 12d and 12d of the pair of wall parts 12a and 12a to prevent the pair of wall parts 12a and 12a from interfering with each other in the crimping step to be described later. It is preferable that the gap portion 13 with a groove-like shape has a minute width from the viewpoint of the contact area described above.

Before the heat pipe group 20 is fixed to the base block 10, the pair of wall parts 12a and 12a protrudes while being inclined relative to the thickness direction of the base block 10, that is, relative to a direction perpendicular to the front-side portion 10b as shown in FIG. 3C. The inclination angle of the pair of wall parts 12a and 12a is not limited to a particular angle, but is 10 degrees with respect to the thickness direction of the base block 10, for example (80 degrees with respect to the planar direction of the base block 10). When the pair of wall parts 12a and 12a protrudes while being inclined relative to the thickness direction of the base block 10, then an equal or nearly equal pressing force can be simultaneously applied to both of the pair of wall parts 12a and 12a in the crimping step to be described later. The base block 10 is provided with a plurality of pairs of wall parts 12a and 12a corresponding to a plurality of recessed parts 11. The pairs of wall parts 12a and 12a are inclined at an equal inclination angle. The pair of wall parts 12a and 12a are formed at, an angle equal to, or nearly equal to, the standing angle of the second tubular portion 21b relative to the base block 10. Particularly, the second tubular portion 21b of the heat pipe 21 is inclined upward toward the tip end of the second tubular portion 21b relative to the thickness direction of the base block 10, and the pair of wall parts 12a and 12a are formed at an inclination angle equal to, or nearly equal to, the inclination angle of the second tubular portion 21b inclined upward toward the tip end.

### [Manufacturing method of cooling device]

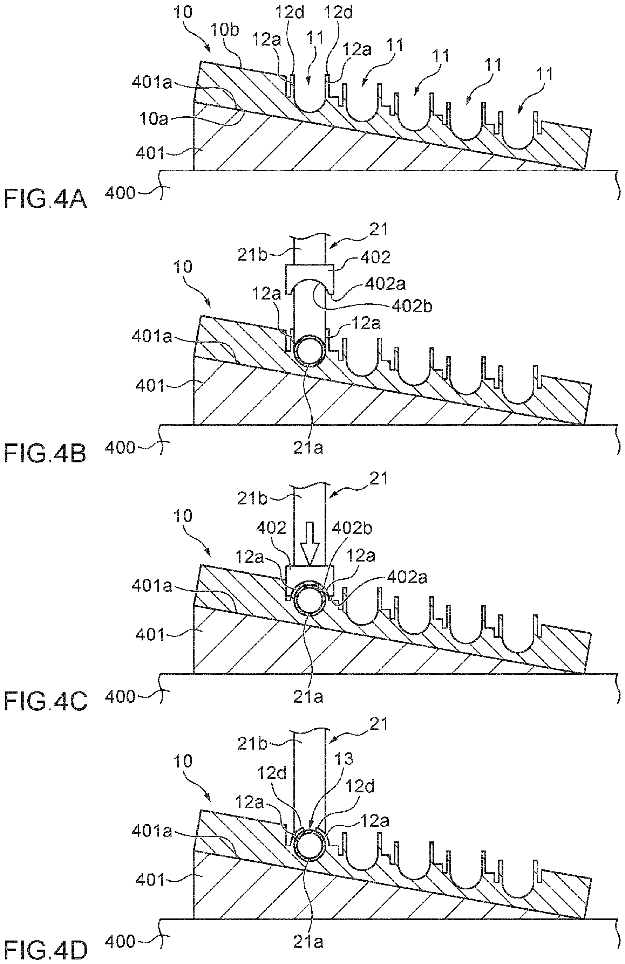

Next, a manufacturing method of the cooling device 1 in FIG. 1 is described with reference to FIGs. 4A to 4D. The manufacturing method of the cooling device shown in FIGs. 4 is merely an example. The manufacturing method of a cooling device of the present invention is not limited to that shown in FIGs. 4.

First, a plurality of the recessed parts 11, each of which extends in the longitudinal direction and the width direction, are formed on the front-side portion 10b of the base block 10. Further, the pair of wall parts 12a and 12a is formed. The pair of wall parts 12a and 12a protrudes linearly from the opposite sides of each recessed part in the width direction, while being inclined relative to the thickness direction of the base block 10 (base-block forming step). At this time, the pair of wall parts 12a and 12a are formed with an equal length in the extending direction. The base block 10 is thereby obtained as shown in FIG. 3C.

Thereafter, a press-fitting base 401 including an inclined portion 401a is mounted on a work table 400, and the base block 10 having been manufactured is placed on the inclined portion 401a and then fixed by using a jig (not shown) (FIG. 4A). At this time, it is preferable to set the inclination angle of the inclined portion 401a such that the pair of wall parts 12a and 12a protrudes in the vertical direction. For example, where the inclination angle of the pair of wall parts 12a and 12a is 10 degrees with respect to the thickness direction of the base block 10 (80 degrees with respect to the planar direction of the base block 10), the inclination angle of the inclined portion 401a is set to 10 degrees with respect to the horizontal direction. The pair of wall parts 12a and 12a with an equal length in the extending direction is formed, and the base block 10 is inclined such that the pair of tip end portions 12d and 12d of the pair of wall parts 12a and 12a is maintained at the same height.

Thereafter, a plurality of the heat pipes 21 are prepared, each of which includes the first tubular portion 21a and the second tubular portion 21b connected to this tubular portion 21a, to accommodate the first tubular portion 21a of the heat pipe 21 in the recessed part 11 of the base block 10 (FIG. 4B). At this time, for example, the second tubular portion 21b of each heat pipe 21 is provided in a standing manner from the base block 10 in the vertical direction. It is preferable to hold the heat pipe 21 such that the second tubular portion 21b is provided in a standing manner in a direction parallel to the pair of wall parts 12a and 12a.

Thereafter, the pair of wall parts 12a and 12a is crimped in a state where the first tubular portion 21a of the heat pipe 21 is accommodated in the recessed part 11 of the base block 10, and where the second tubular portion 21b of the heat pipe 21 is provided in a standing manner from the base block 10 (crimping step) (FIG. 4C). For example, a jig 402 is used, the jig 402 including a groove portion 402b having an inverted U-shape on a bottom portion 402a. The jig 402 is moved downward in the vertical direction (the arrow direction in the drawing) to press the groove portion 402b against the pair of wall parts 12a and 12a to press the pair of wall parts 12a and 12a together.

The pair of wall parts 12a and 12a with an equal or nearly equal length in the extending direction is formed in the base-block forming step described above, the pair of wall parts 12a and 12a are pressed by using a pressing force in the vertical direction in a state where the base block 10 is inclined such that the pair of tip end portions 12d and 12d of the pair of wall parts 12a and 12a is maintained at the same height. Also, in a state where the pair of wall parts 12a and 12a protrudes in the vertical direction, the above pressing force in the vertical direction may be applied to this pair of wall parts 12a and 12a.

The first tubular portion 21a is thereby crimped and fixed to the recessed part 11 and the pair of wall parts 12a and 12a of the base block 10 (FIG. 4D). The crimping step described above is repeatedly performed on the heat pipes 21, so that the heat pipes 21 are fixed to one another through the base block 10.

As the pair of wall parts 12a and 12a has an equal or nearly equal length, and the pair of wall parts 12a and 12a protrudes in the vertical direction, a pressing force can be applied evenly to the pair of wall parts 12a and 12a. It is also preferable to press the pair of wall parts 12a and 12a in a state where the center position of the groove portion 402b in the width direction aligns with the center position of the pair of wall parts 12a and 12a in the width direction when viewed from the side of the jig 402.

The curved-surface shape of the groove portion 402b of the jig 402 is not limited to a particular shape. However, it is preferable that the groove portion 402b has a line-symmetric curved-surface shape with respect to the vertical direction from the viewpoint of applying a pressing force evenly to the pair of wall parts 12a and 12a. In a case where the pair of wall parts 12a and 12a has an equal or nearly equal thickness, and where each wall part 12a has a uniform thickness, it is preferable that the groove portion 402b has a curved-surface shape conforming to the outer peripheral shape of the first tubular portion 21a from the viewpoint of increasing the contact area between the first tubular portion 21a and the pair of wall parts 12a and 12a. For example, when the first tubular portion has a circular outer peripheral shape when viewed in cross-section in the width direction of the first tubular portion, it is preferable that the groove portion 402b has a circular curved-surface shape.

Then, a fin group is formed by fixing a plurality of fins to the heat pipe group 20 formed of the heat pipes 21 fixed to the base block 10, the fins being parallel to each other in the standing direction of the heat pipe group 20 (fin-group forming step). The second tubular portions 21b, 21b, ... are thereby fixed to one another through the fin group 30.

As described above, according to the present embodiment, the first tubular portions 21a, 21a, ... are fixed to one another through the base block 10, and the second tubular portions 21b, 21b, ... are fixed to one another through the fin group 30. Thus, even when vibration or shock acts on the heat sink, the respective distances between the heat pipes 21, 21, ... still remain unchanged, and accordingly a moment of force is minimally generated in the fixed portion between the base block 10 and each of the heat pipes 21 provided in a standing manner from the base block 10. Consequently, a fixing force between the base block 10 and each of the heat pipes 21 is maintained. Therefore, the reliability of joining between the base block 10 and the heat pipe 21 is improved, and high contact thermal conductance and high resistance to vibration can both be achieved. In addition, since it is unnecessary to use lead-free solder, the environmental impacts can be reduced, and this can meet the specifications of a cooling device that is conditional to avoiding the use of lead solder.

The heat pipe 21 is crimped and fixed to the recessed part 11 and the pair of wall parts 12a and 12a provided in the base block 10, so that the heat pipe 21 can be rigidly joined to the base block 10. Particularly, the environmental impacts can be reduced compared to the lead solder, and also the heat pipe 21 is less affected by wettability or other factors as compared to the lead-free solder, so that a stable joining force can be maintained.

Further, the pair of wall parts 12a and 12a is a pair of elongated protruding portions protruding along the outer peripheral surface 21c of the first tubular portion 21a, and extending along the longitudinal direction of the first tubular portion 21a. Each of the pair of elongated protruding portions includes the press-contact surface 12c that press-contacts the outer peripheral surface 21c of the first tubular portion 21a. Thus, a friction force generated between the first tubular portion 21a and the pair of elongated protruding portions can be increased, so that the heat pipe 21 can be more rigidly joined to the base block 10.

According to the present embodiment, a plurality of the heat pipes 21 are prepared, each of which includes the first tubular portion 21a and the second tubular portion 21b, and the pair of wall parts 12a and 12a is crimped in a state where the first tubular portion 21a of the heat pipe 21 is accommodated in the recessed part 11 of the base block 10, and the second tubular portion 21b of the heat pipe 21 is provided in a standing manner from the base block 10 (crimping step). Then, the fin group 30 is formed by fixing a plurality of the fins 31, 31, ... to the heat pipe group 20 formed of the heat pipes 21, 21, ... crimped to the base block 10, the fins 31, 31, ... being parallel to each other in the standing direction of the heat pipe group 20 (fin-group forming step). Therefore, the cooling device 1 can be manufactured without using solder, while improving the reliability of joining between the base block 10 and the heat pipe 21, and having both high contact thermal conductance and high resistance to vibration.

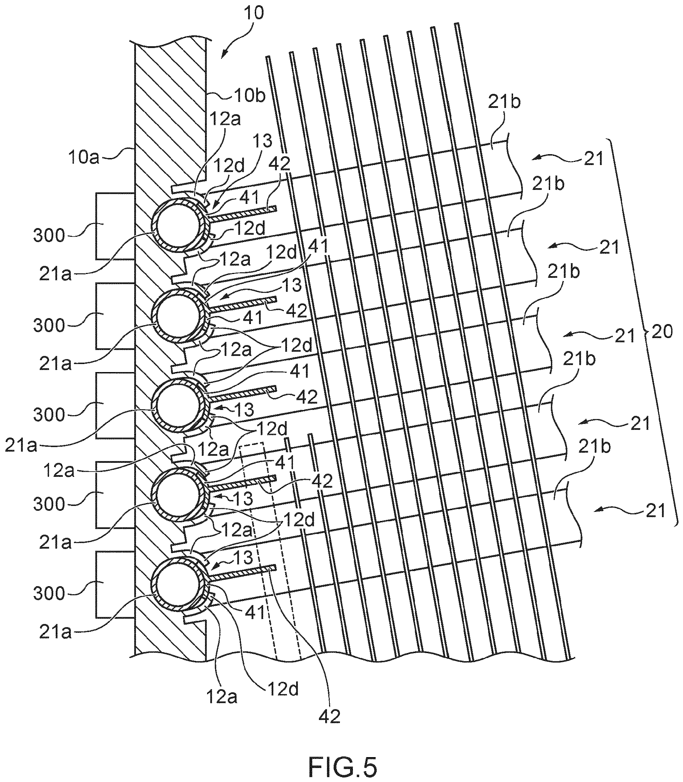

FIG. 5 is a partial cross-sectional view showing a modification of the fixed portion of the heat pipe group 20 to the base block 10 in the cooling device 1 in FIG. 1. In a case where the first tubular portion 21a and the second tubular portion 21b of the heat pipe 21 are formed in one piece, a bent portion is provided between the first tubular portion 21a and the second tubular portion 21b by bending as described above. Accordingly, a dead space is generated where it is difficult to install a fin between the base block 10 and the lowest fin of the fin group 30. For this reason, a fin member is located in this dead space, such that this dead space is effectively utilized.

For example, as shown in FIG. 5, the cooling device 1 may further include a fin member 40 located between the base block 10 and the fin group 30. The fin member 40 includes a plate-like base portion 41 crimped and fixed between the first tubular portion 21a and the pair of wall parts 12a and 12a, and a fin portion 42 connected to the plate-like base portion 41, and provided in a standing manner through the gap portion 13 formed between the tip end portions 12d and 12d of the pair of wall parts 12a and 12a.

It is preferable that the plate-like base portion 41 extends in the longitudinal direction and the width direction, and extends along the longitudinal direction of the first tubular portion 21a (see the X-direction in FIG. 6). It is also preferable that the plate-like base portion 41 has a shape conforming to the outer peripheral shape of the first tubular portion 21a in cross-section in the width direction of the plate-like base portion 41. For example, in a case where the first tubular portion 21a has a circular shape in cross-sectional in the width direction, it is preferable that the plate-like base portion 41 has an arc shape in cross-section in the width direction which is coaxial to the circular shape of the first tubular portion 21a.

It is preferable that the fin portion 42 extends in the longitudinal direction and the width direction similarly to the plate-like base portion 41, and extends along the longitudinal direction of the first tubular portion 21a. In this case, the fin portion 42 is provided along, for example, the horizontal direction.

The fin portion 42 is provided in a standing manner along the standing direction of the second tubular portion 21b, for example, parallel to the standing direction of the second tubular portion 21b. The shape of the fin portion 42 in cross-section in the width direction is not limited to a particular shape, but may be, for example, a linear shape, a curved shaped, or a wavy shape. The fin portion 42 is thermally connected to the plate-like base portion 41 and is, for example, formed integrally with the plate-like base portion 41 in one piece, or joined to the plate-like base portion 41 by welding or other methods.

FIG. 6A is a partially exploded perspective view of the fixed portion in FIG. 5. FIG. 6B is a partially enlarged cross-sectional view of the fixed portion in FIG. 6A. In a case where the fin member 40 in FIG. 5 is attached to the heat pipe 21, prior to the crimping step in the manufacturing method described above, the first tubular portion 21a of the heat pipe 21 is accommodated in the recessed part 11 of the base block 10, and further the fin member 40 is placed on the heat pipe 21 by bringing the plate-like base portion 41 into contact with the first tubular portion 21a. At this time, it is preferable to hold the fin member 40 such that the fin portion 42 of the fin member 40 extends parallel to the standing direction of the second tubular portion 21b.

Then, the pair of wall parts 12a and 12a is crimped in a state where the first tubular portion 21a of the heat pipe 21 is accommodated in the recessed part 11 of the base block 10, while the second tubular portion 21b of the heat pipe 21 is provided in a standing manner from the base block 10, and further the fin portion 42 of the fin member 40 is provided in a standing manner from the base block 10.

When the pair of wall parts 12a and 12a is in a crimped state, each of the pair of wall parts 12a and 12a includes a press-contact surface 12e that press-contacts the outer peripheral surface 21c of the first tubular portion 21a (FIG. 6B). The plate-like base portion 41 is pressed by a pair of press-contact surfaces 12e and 12e, so that the first tubular portion 21a is pressed against the recessed part 11 through the plate-like base portion 41. Both the heat pipe 21 and the plate-like base portion 41 are thereby crimped and fixed to the recessed part 11 and the pair of wall parts 12a and 12a.

According to the present modification, the fin member 40 is located between the base block 10 and the fin group 30. Thus, the dead space where it is difficult to install the fin 31 can be effectively utilized, so that the heat radiating area can be increased.

The plate-like base portion 41 is crimped and fixed between the first tubular portion 21a and the pair of wall parts 12a and 12a. The fin portion 42 is connected to the plate-like base portion 41, and is provided in a standing manner through the gap portion 13 formed between the tip end portions 12d and 12d of the pair of wall parts 12a and 12a. Thus, when the heat pipe 21 is fixed to the base block 10, the fin member 40 can be crimped jointly with the heat pipe 21. Accordingly, a heat sink with an increased heat radiating area while maintaining the contact area can be easily manufactured.

While the cooling device and the manufacturing method of a cooling device according to the present embodiment have been described above, the present invention is not limited to the aforementioned embodiment, but various modifications and variations are possible based on the technical scope of the present invention as defined by the appended claims.

### List of Reference Signs

1 cooling device
10 base block
10a back-side portion
10b front-side portion
11 recessed part
12a, 12a pair of wall parts
12c press-contact surface
12d, 12d pair of tip end portions
12e press-contact surface
13 gap portion
20 heat pipe group
21 heat pipe
21a first tubular portion
21b second tubular portion
21c outer peripheral surface
31 fin
30 fin group
40 fin member
41 plate-like base portion
42 fin portion
100 vehicle
101 underfloor surface
102 attachment
200 casing
201 side wall
202 opening
203 opening-closing cover
204 hinge
205 side wall
206 window hole
207 cover
208a, 208b support plate
300 electrical component
301, 302, 303 other components
400 work table
401 press-fitting base
401a inclined portion
402 jig
402a bottom portion
402b groove portion

## Claims

1. A cooling device comprising:
a base block (10) including a back-side portion (10a) thermally connectable to a heating element (300);
a heat pipe group (20) formed of a plurality of heat pipes (21), each of which includes a first tubular portion (21a) and a second tubular portion (21b), the first tubular portion being fixed to a front-side portion (10b) of the base block and being disposed along a planar direction of the base block, the second tubular portion being connected to the first tubular portion and being provided in a standing manner from the base block; and
a fin group (30) formed of a plurality of fins (31) fixed to the heat pipe group, the fins being parallel to each other in a standing direction of the heat pipe group, wherein
a plurality of the first tubular portions are fixed to one another through the base block, while a plurality of the second tubular portions are fixed to one another through the fin group,
the base block includes
a recessed part (11) extending in a longitudinal direction and a width direction, and having the first tubular portion accommodated therein, and
a pair of wall parts (12a) protruding from opposite sides of the recessed part in the width direction along an outer peripheral surface of the first tubular portion,
the heat pipe is crimped and fixed to the recessed part and the pair of wall parts,
the pair of wall parts has an equal or nearly equal length in a protruding direction,
the base block is located along a vertical direction,
the first tubular portion of the heat pipe is provided along a horizontal direction,
the second tubular portion of the heat pipe is inclined upward toward a tip end relative to a thickness direction of the base block, and
the pair of wall parts is formed at an inclination angle equal to, or nearly equal to, the inclination angle of the second tubular portion inclined upward toward the tip end.

2. The cooling device according to claim 1, wherein
the pair of wall parts is a pair of elongated protruding portions protruding along the outer peripheral surface of the first tubular portion, and extending along the longitudinal direction of the first tubular portion, and
each of the pair of elongated protruding portions includes a press-contact surface (12c) that press-contacts the outer peripheral surface of the first tubular portion.

3. The cooling device according to claim 1 or 2, wherein
a gap portion (13) with a groove-like shape is formed between tip end portions of the pair of wall parts.

4. The cooling device according to any one of claims 1 to 3, further comprising a fin member (40) located between the base block and the fin group, wherein
the fin member includes a plate-like base portion (41) crimped and fixed between the first tubular portion and the pair of wall parts, and a fin portion (42) connected to the plate-like base portion and provided in a standing manner through the gap portion formed between the tip end portions of the pair of wall parts.

5. A manufacturing method of a cooling device, **characterized by** comprising:
a base-block forming step of forming a plurality of recessed parts (11), each of which extends in a longitudinal direction and a width direction, on a front-side portion (10b) of a base block (10), and further forming a pair of wall parts (12a) protruding linearly from opposite sides of each of the recessed parts in the width direction, while being inclined relative to a thickness direction of the base block;
a crimping step of preparing a plurality of heat pipes (21), each of which includes a first tubular portion and a second tubular portion connected to the first tubular portion, and crimping the pair of wall parts in a state where the first tubular portion of the heat pipe is accommodated in the recessed part of the base block, and the second tubular portion of the heat pipe is provided in a standing manner from the base block; and
a fin-group forming step of forming a fin group (30) by fixing a plurality of fins (31) to a heat pipe group formed of the heat pipes crimped to the base block, the fins being parallel to each other in a standing direction of the heat pipe group,
wherein in the base-block forming step, the pair of wall parts having an equal or nearly equal length in an extending direction is formed, and
wherein in the crimping step, the pair of wall parts is pressed by a pressing force in a vertical direction in a state where the base block is inclined such that a pair of tip end portions of the pair of wall parts is maintained at a same height.

6. The manufacturing method of the cooling device according to claim 5, wherein in the crimping step, in a state where the pair of wall parts protrudes in a vertical direction, a pressing force in the vertical direction is applied to the pair of wall parts.

7. The manufacturing method of the cooling device according to claim 5 or 6, wherein in the crimping step, a jig (402) including a groove portion (402b) with an inverted U-shape is used to press the groove portion against the pair of wall parts to press the pair of wall parts together.

## Patentansprüche

1. Kühlvorrichtung, die umfasst:
einen Basisblock (10) mit einem Rückseitenabschnitt (10a), der thermisch mit einem Heizelement (300) verbunden werden kann;
eine Wärmerohrgruppe (20), die aus einer Vielzahl von Wärmerohren (21) gebildet ist, von denen jedes einen ersten röhrenförmigen Abschnitt (21a) und einen zweiten röhrenförmigen Abschnitt (21b) aufweist, wobei der erste röhrenförmige Abschnitt an einem vorderseitigen Abschnitt (10b) des Basisblocks befestigt ist und entlang einer ebenen Richtung des Basisblocks angeordnet ist, wobei der zweite röhrenförmige Abschnitt mit dem ersten röhrenförmigen Abschnitt verbunden ist und in einer stehenden Weise von dem Basisblock vorgesehen ist; und
eine Rippengruppe (30), die aus einer Vielzahl von Rippen (31) besteht, die an der Wärmerohrgruppe befestigt sind, wobei die Rippen in einer Stehrichtung der Wärmerohrgruppe parallel zueinander sind, wobei
eine Vielzahl der ersten rohrförmigen Abschnitte durch den Basisblock aneinander befestigt sind, während eine Vielzahl der zweiten rohrförmigen Abschnitte durch die Rippengruppe aneinander befestigt sind,
der Basisblock umfasst
ein vertieftes Teil (11), der sich in einer Längsrichtung und in einer Breitenrichtung erstreckt und in dem der erste rohrförmige Abschnitt untergebracht ist, und
ein Paar von Wandteilen (12a), die von gegenüberliegenden Seiten des vertieften Teils in der Breitenrichtung entlang einer äußeren Umfangsfläche des ersten rohrförmigen Abschnitts vorstehen,
das Wärmerohr an den vertieften Teil und das Paar Wandteile gepresst und befestigt ist,
das Paar von Wandteilen eine gleiche oder nahezu gleiche Länge in einer vorspringenden Richtung aufweist,
der Basisblock entlang einer vertikalen Richtung angeordnet ist,
der erste rohrförmige Abschnitt des Wärmerohrs entlang einer horizontalen Richtung angeordnet ist,
der zweite röhrenförmige Abschnitt des Wärmerohrs relativ zu einer Dickenrichtung des Basisblocks zu einem Spitzenende hin nach oben geneigt ist, und
das Paar von Wandteilen in einem Neigungswinkel ausgebildet ist, der gleich oder nahezu gleich dem Neigungswinkel des zweiten rohrförmigen Abschnitts ist, der nach oben zum Spitzenende hin geneigt ist.

2. Kühlvorrichtung nach Anspruch 1, wobei
das Paar von Wandteilen ein Paar von länglichen vorstehenden Abschnitten ist, die entlang der äußeren Umfangsfläche des ersten rohrförmigen Abschnitts vorstehen und sich entlang der Längsrichtung des ersten rohrförmigen Abschnitts erstrecken, und
jeder des Paars länglicher vorstehender Abschnitte eine Druckkontaktfläche (12c) aufweist, die mit der äußeren Umfangsfläche des ersten rohrförmigen Abschnitts in Druckkontakt steht.

3. Kühlvorrichtung nach Anspruch 1 oder 2, wobei
ein Spaltabschnitt (13) mit einer rillenartigen Form zwischen den Spitzenendabschnitten des Paares von Wandteilen gebildet ist.

4. Kühlvorrichtung nach einem der Ansprüche 1 bis 3, ferner mit einem Rippenelement (40), das zwischen dem Basisblock und der Rippengruppe angeordnet ist, wobei
das Rippenelement einen plattenartigen Basisabschnitt (41) aufweist, der zwischen dem ersten rohrförmigen Abschnitt und dem Paar von Wandteilen gefalzt und befestigt ist, und einen Rippenabschnitt (42), der mit dem plattenartigen Basisabschnitt verbunden ist und in stehender Weise durch den Spaltabschnitt vorgesehen ist, der zwischen den Spitzenendabschnitten des Paares von Wandteilen gebildet ist.

5. Herstellungsverfahren für eine Kühlvorrichtung, **dadurch gekennzeichnet, dass** es umfasst:
einen Basisblock-Bildungsschritt eines Bildens einer Vielzahl von vertieften Teilen (11), von denen sich jedes in einer Längsrichtung und einer Breitenrichtung erstreckt, an einem Vorderseitenabschnitt (10b) eines Basisblocks (10), und des Weiteren eines Bildens eines Paars von Wandteilen (12a), die linear von gegenüberliegenden Seiten jedes der vertieften Teile in der Breitenrichtung vorstehen, während sie relativ zu einer Dickenrichtung des Basisblocks geneigt sind;
einen Pressschritt eines Vorbereitens einer Vielzahl von Wärmerohren (21), von denen jedes einen ersten röhrenförmigen Abschnitt und einen zweiten röhrenförmigen Abschnitt, der mit dem ersten röhrenförmigen Abschnitt verbunden ist, umfasst, und eines Pressens des Paars von Wandteilen in einem Zustand, in dem der erste röhrenförmige Abschnitt des Wärmerohrs in dem vertieften Teil des Basisblocks untergebracht ist und der zweite röhrenförmige Abschnitt des Wärmerohrs in einer stehenden Weise von dem Basisblock bereitgestellt ist; und
einen Rippengruppenbildungsschritt eines Bildens einer Rippengruppe (30) durch Befestigen einer Vielzahl von Rippen (31) an einer Wärmerohrgruppe, die aus den an den Basisblock gepressten Wärmerohren gebildet ist, wobei die Rippen in einer Stehrichtung der Wärmerohrgruppe parallel zueinander sind,
wobei in dem Schritt des Bildens des Basisblocks das Paar von Wandteilen mit einer gleichen oder nahezu gleichen Länge in einer Erstreckungsrichtung gebildet wird, und
wobei in dem Pressschritt das Paar von Wandteilen durch eine Presskraft in einer vertikalen Richtung in einem Zustand gepresst wird, in dem der Basisblock so geneigt ist, dass ein Paar von Spitzenendabschnitten des Paars von Wandteilen auf einer gleichen Höhe gehalten wird.

6. Herstellungsverfahren für die Kühlvorrichtung nach Anspruch 5, bei dem in dem Pressschritt in einem Zustand, in dem das Paar von Wandteilen in vertikaler Richtung vorsteht, eine Druckkraft in vertikaler Richtung auf das Paar von Wandteilen ausgeübt wird.

7. Herstellungsverfahren für die Kühlvorrichtung nach Anspruch 5 oder 6, bei dem in dem Pressschritt eine Vorrichtung (402) mit einem Nutabschnitt (402b) mit einer umgekehrten U-Form verwendet wird, um den Nutabschnitt gegen das Paar von Wandteilen zu drücken, um das Paar von Wandteilen zusammenzupressen.

## Revendications

1. Dispositif de refroidissement comprenant:
un bloc de base (10) comprenant une portion côté arrière (10a) pouvant être reliée thermiquement à un élément de chauffage (300);
un groupe de caloducs (20) formé d'une pluralité de caloducs (21), dont chacun comprend une première portion tubulaire (21a) et une seconde portion tubulaire (21b), la première portion tubulaire étant fixée à une partie côté avant (10b) du bloc de base et étant disposée le long d'une direction plane du bloc de base, la seconde portion tubulaire étant reliée à la première portion tubulaire et étant disposée debout par rapport au bloc de base; et
un groupe d'ailettes (30) formé d'une pluralité d'ailettes (31) fixées au groupe de caloducs, les ailettes étant parallèles les unes aux autres dans une direction verticale du groupe de caloducs, dans lequel
une pluralité des premières portions tubulaires sont fixées les unes aux autres par le bloc de base tandis qu'une pluralité des secondes portions tubulaires sont fixées les unes aux autres par le groupe d'ailettes,
le bloc de base comprend une partie en retrait (11) s'étendant dans une direction longitudinale et une direction de la largeur, et ayant la première portion tubulaire logée en son sein, et
une paire de parties de paroi (12a) faisant saillie des côtés opposés de la partie en retrait dans la direction de la largeur le long d'une surface périphérique externe de la première portion tubulaire,
le caloduc est serti et fixé à la partie en retrait et à la paire de parties de paroi,
la paire de parties de paroi a une longueur égale ou approximativement égale dans une direction de saillie,
le bloc de base est situé le long d'une direction verticale,
la première portion tubulaire du caloduc est disposée le long d'une direction horizontale,
la seconde portion tubulaire du caloduc est inclinée vers le haut en direction d'une extrémité de pointe par rapport à une direction d'épaisseur du bloc de base, et
la paire de parties de paroi est formée selon un angle d'inclinaison égal à, ou approximativement égal à, l'angle d'inclinaison de la seconde portion tubulaire inclinée vers le haut en direction de l'extrémité de pointe.

2. Dispositif de refroidissement selon la revendication 1, dans lequel
la paire de parties de paroi est une paire de portions en saillie allongées faisant saillie le long de la surface périphérique externe de la première portion tubulaire, et s'étendant le long de la direction longitudinale de la première portion tubulaire, et
chacune de la paire de portions en saillie allongées comprend une surface de contact par pression (12c) qui entrent en contact par pression avec la surface périphérique externe de la première portion tubulaire.

3. Dispositif de refroidissement selon la revendication 1 ou 2, dans lequel une portion d'espace (13) ayant la forme d'une rainure est formée entre des portions d'extrémité de pointe de la paire de parties de paroi.

4. Dispositif de refroidissement selon l'une quelconque des revendications 1 à 3, comprenant en outre un élément d'ailette (40) situé entre le bloc de base et le groupe d'ailettes, dans lequel l'élément d'ailette comprend une partie de base en forme de plaque (41) sertie et fixée entre la première portion tubulaire et la paire de parties de paroi, et une portion d'ailette (42) reliée à la partie de base en forme de plaque et disposée debout à travers la portion d'espace formée entre les portions d'extrémité de pointe de la paire de parties de paroi.

5. Procédé de fabrication d'un dispositif de refroidissement, **caractérisé en ce qu'**il comprend:
une étape de formation de bloc de base consistant à former une pluralité de parties en retrait (11), dont chacune s'étend dans une direction longitudinale et une direction de largeur, sur une portion côté avant (10b) d'un bloc de base (10), et en outre formant une paire de parties de paroi (12a) faisant saillie linéairement des côtés opposés de chacune des parties en retrait dans la direction de largeur, tout en étant inclinée par rapport à une direction d'épaisseur du bloc de base;
une étape de sertissage de préparation d'une pluralité de caloducs (21), dont chacun comprend une première portion tubulaire (21a) et une seconde portion tubulaire (21b) reliée à la première portion tubulaire, et de sertissage de la paire de parties de paroi lorsque la première portion tubulaire du caloduc est logée dans la partie en retrait du bloc de base, et que la seconde portion tubulaire du caloduc est disposée debout par rapport au bloc de base; et
une étape de formation de groupe d'ailettes consistant à former un groupe d'ailettes (30) par fixation d'une pluralité d'ailettes (31) à un groupe de caloducs formés des caloducs sertis au bloc de base, les ailettes étant parallèles les unes aux autres dans une direction verticale du groupe de caloducs,
dans lequel dans l'étape de formation de bloc de base, la paire de parties de paroi ayant une longueur égale ou approximativement égale est formée dans une direction d'extension, et
dans lequel dans l'étape de sertissage, la paire de parties de paroi est pressée par une force de pressage dans une direction verticale lorsque le bloc de base est incliné de sorte qu'une paire de parties d'extrémité de pointe de la paire de parties de paroi soit maintenue à une même hauteur.

6. Procédé de fabrication du dispositif de refroidissement selon la revendication 5, dans lequel dans l'étape de sertissage, lorsque la paire de parties de paroi fait saillie dans une direction verticale, une force de pressage dans la direction verticale est appliquée à la paire de parties de paroi.

7. Procédé de fabrication du dispositif de refroidissement selon la revendication 5 ou 6, dans lequel dans l'étape de sertissage, un gabarit (402) comprenant une portion de rainure (402b) ayant une forme de U inversé est utilisé pour presser la portion de rainure contre la paire de parties de paroi pour presser la paire de parties de paroi ensemble.
